Europäisches Patentamt

European Patent Office

Office européen des brevets

(19)

(11) **EP 1 168 359 B1**

(12) **FASCICULE DE BREVET EUROPEEN**

(45) Date de publication et mention
de la délivrance du brevet:
**18.02.2004 Bulletin 2004/08**

(51) Int Cl.⁷: $G11C\ 11/4094$

(21) Numéro de dépôt: **01401558.0**

(22) Date de dépôt: **14.06.2001**

(54) **Procédé de commande d'un accès en lecture d'une mémoire vive dynamique et mémoire correspondante.**

Vefahren zur Steurung eines Lesezugriffs auf einen dynamischen Speicher und Speicher dazu

Read access control method for a dynamique memory and corresponding memory

(84) Etats contractants désignés:
**DE FR**

(30) Priorité: **26.06.2000 FR 0008131**

(43) Date de publication de la demande:
**02.01.2002 Bulletin 2002/01**

(73) Titulaire: **STMicroelectronics SA**
**F-92120 Montrouge (FR)**

(72) Inventeur: **Ferrant, Richard**
**38190 Crolles (FR)**

(74) Mandataire: **Casalonga, Axel**
**BUREAU D.A. CASALONGA - JOSSE**
**Paul-Heyse-Strasse 33**
**80336 München (DE)**

(56) Documents cités:
**US-A- 5 701 268**

**Description**

L'invention concerne les mémoires vives dynamiques (DRAM : "Dynamic Random Access Memory" en langue anglaise), et notamment la commande d'un accès en lecture et plus particulièrement le contrôle du fonctionnement des amplificateurs de lecture/réécriture.

L'invention s'applique avantageusement mais non limitativement aux mémoires dynamiques dites "embarquées" ("embedded DRAM" en langue anglaise), c'est-à-dire des mémoires qui sont par exemple réalisées conjointement à d'autres composants par un même procédé (process) technologique, et destinés à être intégrés ensemble au sein d'un circuit intégré spécifique (ASIC).

Par opposition aux mémoires vives statiques (SRAM), dans laquelle l'information mémorisée le reste indéfiniment du moins tant que cette mémoire reste alimentée, les mémoires dynamiques présentent la particularité de nécessiter un rafraîchissement périodique de l'information stockée en raison notamment des courants de fuite parasites qui déchargent la capacité de stockage de chaque point mémoire.

Parmi les cellules de mémoires vives dynamiques, on peut notamment citer celles comportant un, deux ou trois transistors.

Classiquement, les mémoires vives dynamiques sont organisées en lignes et en colonnes de cellules-mémoire. Chaque colonne comporte une métallisation communément appelée "ligne de bit" (bit line en langue anglaise) et une ligne de bit immédiatement adjacente appelée ligne de bit de référence ou "bit line not". Il est par ailleurs prévu des moyens de précharge par colonne pour précharger la ligne de bit et la ligne de bit de référence de la colonne avant un accès en lecture de la mémoire. La précharge des lignes de bit et des lignes de bit de référence s'effectue généralement à une tension égale à Vdd/2 dans le cas où la tension d'alimentation Vdd représente la tension de mémorisation d'un état haut (typiquement un "1" logique) et 0 volt (la masse) représente la tension de mémorisation d'un état bas (typiquement un "0" logique).

La plupart des mémoires DRAM utilisent une rangée de cellules dites de "référence", également connectées sur les lignes de bit et les lignes de bit de référence, pour égaliser les charges des lignes de bit et des lignes de bit de référence et maximiser l'amplitude moyenne du signal entre les "0" et les "1".

Il est également prévu d'autres moyens de précharge pour précharger cette rangée de cellules dites de "référence". La précharge des cellules de référence s'effectue également généralement à Vdd/2.

Lors d'un accès en lecture d'une cellule-mémoire connectée sur une ligne de bit, on sélectionne (on active) cette cellule et la cellule de référence connectée sur la ligne de bit de référence, puis on détecte le signe de la différence de tension entre la ligne de bit et la ligne de bit de référence de façon à déterminer le contenu logique "0" ou " 1 " de la cellule-mémoire.

Ces détections s'effectuent classiquement à l'aide d'un amplificateur de lecture/réécriture, connecté entre la ligne de bit et la ligne de bit de référence. Cet amplificateur comporte généralement deux inverseurs rebouclés (formant une bascule bistable), formés chacun de deux transistors complémentaires et commandés par deux signaux successifs de lecture et de réécriture (communément dénommés respectivement "sense" et "restore" en langue anglaise).

Lors de l'activation du signal "restore", la donnée lue dans la mémoire est réécrite, rafraîchissant ainsi le contenu de cette cellule.

Une telle structure classique de mémoire présente certains inconvénients.

En effet, après la précharge de la ligne de bit et de la ligne de bit de référence d'une colonne et lors de la sélection de la cellule-mémoire, la tension aux grilles des deux transistors NMOS de l'amplificateur de lecture/réécriture est sensiblement de l'ordre de Vdd/2. Or, lors de l'activation du signal "sense", la source de ces deux transistors NMOS est alors portée à la masse. Il en résulte que la tension grille-source de ces transistors NMOS est alors sensiblement égale à Vdd/2. Or, ces transistors sont passants si la tension grille-source est supérieure à la tension de seuil de ces transistors.

Et, avec l'évolution de la technologie, le niveau de la tension d'alimentation chute, alors que la tension de seuil d'un transistor NMOS reste sensiblement constante. Ainsi, pour une technologie 0,18 micron, la tension d'alimentation est de l'ordre de 1,8 volts, tandis que pour une technologie 0,12 micron, elle est de l'ordre de 1,2 volts.

En conséquence, avec les technologies avancées, en particulier les technologies 0,15 micron et moins, la différence entre la tension grille-source du transistor NMOS et sa tension de seuil peut devenir très faible jusqu'à devenir inférieure à la tension de seuil ("offset") de l'amplificateur, conduisant à une réécriture et à un rafraîchissement érronés de la donnée lue. Dans le pire des cas, cette différence de tension peut être négative, ce qui ne permet pas de rendre passants les transistors NMOS de l'amplificateur et par conséquent empêche son fonctionnement.

le document US 5 701268 A décrit mémoire DRAM comportant une ligne de bit et une ligne de bit de référence ainsi que des condensateurs qui "stimulent" ("boost" en langue anglaise) les lignes de bits avant la phase de lecture. L'amplificateur de lecture peut ainsi opérer à tension d'alimentation réduite.

L'invention vise à apporter une solution à ce problème.

L'invention a pour but de garantir le bon fonctionnement de l'amplificateur de lecture/réécriture, notamment pour des technologies avancées, telles que des technologies 0,15 ou 0,12 micron, voire moins.

L'invention propose donc un procédé de commande d'un accès en lecture d'une cellule-mémoire d'un plan-mémoire d'un dispositif de mémoire vive dynamique, ladite cellule-mémoire étant connectée à une ligne de bit du plan-mémoire et associée à un amplificateur de lecture/réécriture connecté entre la ligne de bit et une ligne de bit de référence. Le procédé de commande comporte une phase de précharge de la ligne de bit et de la ligne de bit de référence à une tension de précharge prédéterminée (par exemple Vdd/2) et une phase de lecture et de rafraîchissement du contenu de la cellule-mémoire dans laquelle on sélectionne la cellule-mémoire et on active l'amplificateur de lecture/réécriture.

Selon une caractéristique générale de l'invention, entre la phase de précharge et la phase de lecture et de rafraîchissement, on connecte respectivement sur la ligne de bit et sur la ligne de bit de référence deux condensateurs préalablement chargés à une tension de charge supérieure à la tension de précharge, par exemple à une tension de charge égale à Vdd.

En d'autres termes, selon l'invention, on augmente ainsi avant la phase de lecture et de rafraîchissement, la tension de mode commun de l'amplificateur de lecture/réécriture, de façon à augmenter la tension sur la grille des transistors NMOS et par conséquent obtenir une différence de tension grille-source aux bornes des transistors NMOS plus importante, même avec une tension d'alimentation plus faible.

Selon un mode de mise en oeuvre de l'invention, on charge chaque condensateur pendant une durée prédéterminée, par exemple pendant la durée de précharge des lignes de bit et des lignes de bit de référence, et on stoppe la charge juste avant de connecter le condensateur ainsi chargé à la ligne de bit correspondante. Le fait de stopper la charge juste avant de connecter le condensateur à la ligne de bit correspondante, permet ainsi de minimiser les fuites parasites.

L'invention propose également un dispositif de mémoire vive dynamique, comprenant :

- un plan-mémoire comportant des colonnes formées chacune d'une ligne de bit et d'une ligne de bit de référence, sur lesquelles sont connectées des rangées de cellules-mémoire,
- un amplificateur commandable de lecture/réécriture connecté sur chaque colonne du plan-mémoire,
- des moyens commandables de sélection d'une rangée de cellules-mémoire,
- des moyens commandables de précharge de colonne, connectés sur chaque colonne, pour précharger la ligne de bit et la ligne de bit de référence de ladite colonne à une tension de précharge prédéterminée,
- deux condensateurs respectivement connectés à la ligne de bit et à la ligne de bit de référence d'une colonne par deux interrupteurs de connexion commandables,
- des moyens commandables de charge aptes à charger chaque condensateur à une tension de charge supérieure à la tension de précharge, et
- des moyens de commande aptes à activer les moyens de charge des condensateurs et à activer successivement les moyens de précharge, les deux interrupteurs de connexion, les moyens de sélection et l'amplificateur de lecture/réécriture.

Selon un mode de réalisation de l'invention, les moyens de commande sont aptes à activer les moyens de charge pendant une durée prédéterminée, puis à désactiver les moyens de charge juste avant de fermer les deux interrupteurs de connexion.

Les moyens de charge comportent avantageusement pour chaque condensateur, un interrupteur de charge commandable connecté entre une source de tension délivrant ladite tension de charge (par exemple la tension d'alimentation), et une borne du condensateur.

D'autres avantages et caractéristiques de l'invention apparaîtront à l'examen de la description détaillée de modes de mise en oeuvre et de réalisation, nullement limitatifs, et des dessins annexés, sur lesquels :

- la figure 1 illustre schématiquement l'architecture d'une mémoire vive dynamique selon l'invention;
- la figure 2 illustre plus particulièrement mais toujours schématiquement l'architecture interne d'un amplificateur de lecture/réécriture; et
- la figure 3 représente un chronogramme temporel illustrant une mise en oeuvre du procédé selon l'invention.

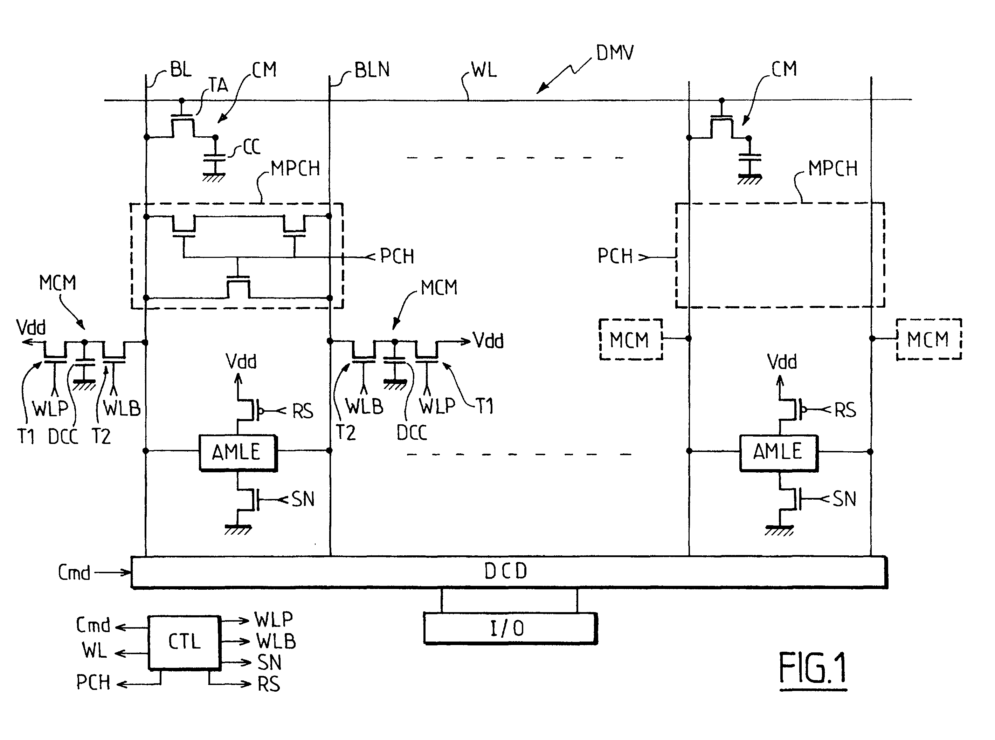

Sur la figure 1, la référence DMV désigne d'une façon générale un dispositif de mémoire vive selon l'invention. Ce dispositif de mémoire vive comprend un plan-mémoire comportant des cellules-mémoire CM organisées en lignes et en colonnes.

Chaque cellule-mémoire CM est ici une cellule-mémoire comportant un transistor d'accès TA et un condensateur de stockage CC. Bien entendu, l'invention n'est pas limitée à ce type de cellule-mémoire vive dynamique.

Toutes les cellules CM d'une même rangée peuvent être simultanément activées par un signal d'activation WL se propageant sur une ligne de mots ("word line" en langue anglaise). En effet, les grilles du transistor TA de ces cellules-mémoire CM sont connectées à cette ligne de mot WL. Par ailleurs, toutes les cellules de la rangée sont respectivement reliées à des métallisations de colonne BL ou ligne de bit (bit line).

A chaque ligne de bit BL, est par ailleurs associée une ligne de bit immédiatement adjacente BLN, communément appelée par l'homme du métier ligne de bit de référence (ou "bit line not" en langue anglaise). Ces lignes de bit BLN permettent de connecter en quinconce d'autres rangées de cellules-mémoire. Bien entendu, pour une cellule-mémoire connectée sur une ligne de bit BLN, la ligne de bit BL fait alors office de ligne de bit de référence.

Au pied de chaque colonne est prévu un décodeur colonne DCD de structure classique et connue en soi, commandé par un signal de décodage de colonne Cmd. Ce décodeur colonne DCD permet de sélectionner l'une des colonnes du plan-mémoire afin de permettre la délivrance à l'interface de sortie I/O du dispositif de mémoire vive, du contenu de la cellule-mémoire placée à l'intersection de la colonne sélectionnée et de la rangée sélectionnée.

Le dispositif de mémoire vive DMV comporte par ailleurs des moyens commandables de précharge de colonne MPCH, de structure classique et connue en soi. Ces moyens MPCH sont par exemple ici formés par trois transistors commandés par le signal PCH. Ces moyens de précharge sont en fait ici des moyens de "pincement" de la ligne de bit BL et de la ligne de bit de référence BLN d'une colonne, et permettent lors du pincement, c'est-à-dire lorsque les trois transistors sont passants, d'égaliser le potentiel de la ligne de bit et de la ligne de bit de référence.

Tous les moyens de précharge MPCH du dispositif de mémoire vive peuvent être connectés à un générateur (non représenté ici à des fins de simplification) qui permet de maintenir les tensions de précharge des lignes de bit et des lignes de bit de référence dans le cas par exemple d'inutilisation prolongée des mémoires, et ce, afin de limiter les effets de fuite de courant.

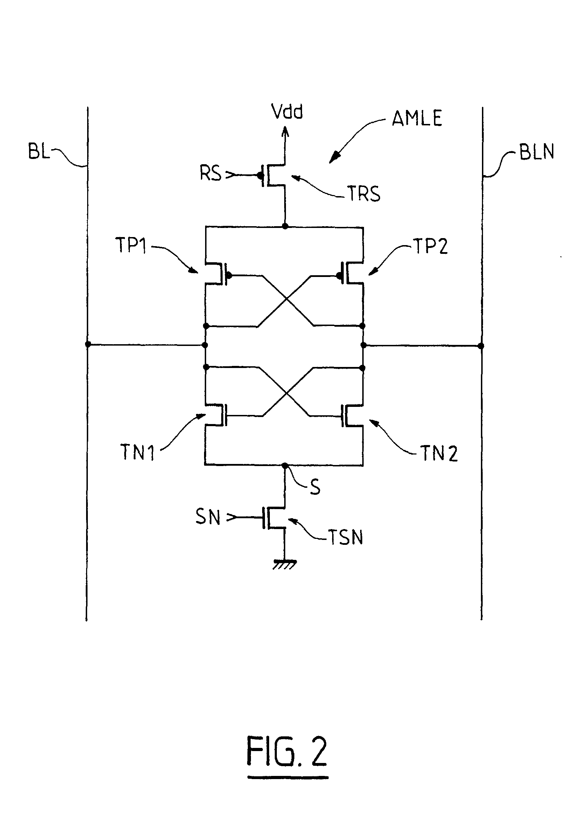

Le dispositif de mémoire vive DMV comporte par ailleurs, de façon classique, un amplificateur commandable de lecture/réécriture AMLE connecté sur chaque colonne du plan-mémoire. Plus précisément, cet amplificateur de lecture/réécriture est connecté entre la ligne de bit BL et la ligne de bit de référence BLN de la colonne. La structure d'un tel amplificateur de lecture/réécriture est connue de l'homme du métier, notamment par la demande de brevet français n° 2 768 847. La figure 2 en illustre schématiquement les aspects essentiels.

Ainsi, l'amplificateur AMLE comporte deux amplificateurs rebouclés, formés de deux transistors PMOS référencés TP1 et TP2, et de deux transistors NMOS référencés TN1 et TN2. Les sources S de ces deux transistors NMOS sont reliées à la masse par l'intermédiaire d'un transistor de commande TSN commandé sur sa grille par un signal de lecture SN (signal "sense"). De même, les sources des deux transistors PMOS TP1 et TP2 sont reliées à la tension d'alimentation Vdd par l'intermédiaire d'un autre transistor de commande TRS commandé sur sa grille par un signal de réécriture RS ("restore").

Les grilles des transistors TN1 et TN2 notamment, sont reliées de façon croisée à la ligne de bit BL et à la ligne de bit de référence BLN.

Outre les moyens qui viennent d'être décrits, le dispositif de mémoire vive DMV selon l'invention comporte des moyens MCM connectés sur la ligne de bit BL et sur la ligne de bit de référence BLN de chaque colonne et destinés, comme on le verra plus en détail ci-après, à surélever la tension de mode commun de l'amplificateur AMLE.

Chaque moyen MCM comporte un condensateur DCC dont une borne est reliée à la masse et dont l'autre borne est reliée,

d'une part, à la ligne de bit correspondante (ligne de bit BL ou ligne de bit BLN) par un transistor T2, commandé sur sa grille par un signal de commande WLB et faisant office ici d'interrupteur de connexion commandable, et, d'autre part, à la tension d'alimentation Vdd par un autre transistor T1 commandé sur sa grille par un autre signal de commande WLP et faisant office ici d'interrupteur de charge commandable.

On n'a pas représenté sur la figure 1 les cellules de référence connectées sur les lignes de bit et les lignes de bit de référence, à des fins de simplification.

Le signal d'activation WL, véhiculé par la métallisation portant la même référence, ainsi que les signaux de commande SN, RS, Cmd, PCH, WLB, WLP, sont délivrés par des moyens de commande CTL qui peuvent être classiquement réalisés à base de porte logique.

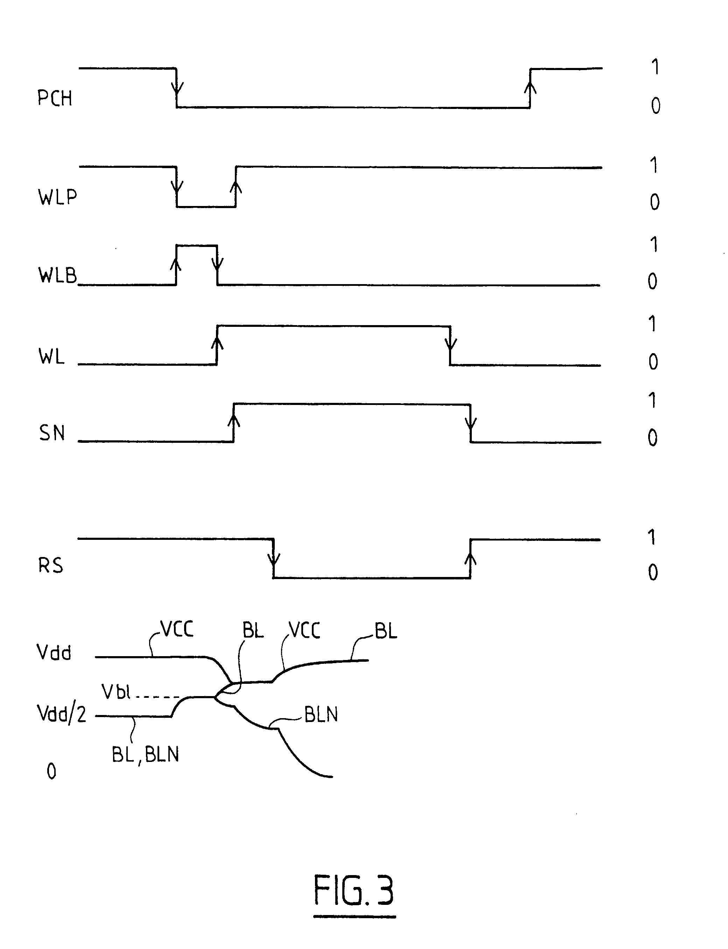

On se réfère maintenant plus particulièrement à la figure 3, pour décrire un mode de mise en oeuvre du procédé selon l'invention.

Sur la figure 3, on suppose que la tension d'alimentation est égale à Vdd et que la cellule-mémoire CM stocke un "1" logique. On suppose, par ailleurs que, après l'accès en lecture précédent, la ligne de bit et la ligne de bit BLN ont été préalablement préchargées à la tension de précharge égale à Vdd/2, obtenue par pincement de la ligne BL et de la ligne BLN (signal PCH à l'état 1).

On suppose également que, pendant cette phase de précharge de la ligne de bit et de la ligne de bit de référence de chaque colonne, le condensateur DCC de chaque moyen MCM a été chargé à la tension d'alimentation Vdd (transistor T1 passant, signal WLP à l'état 1).

Puisque la cellule-mémoire stocke un " 1 " logique, la tension VCC aux bornes de la capacité de mémorisation CC de la cellule-mémoire est égale à Vdd (en négligeant les courants de fuite).

Lorsque l'on interrompt la précharge des lignes de bit et que l'on déconnecte le condensateur DCC de la tension d'alimentation (signal WLP à 0), on connecte le condensateur DCC à la ligne de bit correspondante en fermant l'interrupteur de connexion T2 (signal WLB à 1).

A ce moment-là, les charges contenues dans le condensateur DCC sont transférées sur la ligne de bit et la ligne de bit de référence selon l'équation (I) ci-dessous :

$$(Cbl + Ccell) \cdot Vbl = Cbl \cdot \frac{Vdd}{2} + Ccell \cdot Vdd \tag{I}$$

dans laquelle Cbl représente la valeur capacitive d'une ligne de bit (ou d'une ligne de bit de référence), Ccell représente la valeur capacitive du condensateur DCC, Vbl représente la tension sur la ligne de bit (ou la ligne de bit de référence) et Vdd la tension d'alimentation.

Il en résulte donc que la tension Vbl sur chacune des lignes de bit est définie par l'équation (II) ci-dessous :

$$Vbl = \left[ \frac{Cbl}{2 \cdot (Cbl + Ccell)} + \frac{Ccell}{(Cbl + Ccell)} \right] \cdot Vdd \tag{II}$$

Ceci se traduit donc par une augmentation importante de la tension sur la ligne de bit comme illustré sur le bas de la figure 3.

A titre indicatif, pour une valeur capacitive Cbl égale à 100 fF et une valeur Ccell égale à 30 *f*F, la tension Vbl est égale à 0,615 Vdd.

Avant d'activer le signal WL, et de préférence juste avant d'activer ce signal WL, on désactive le signal WLB, c'est-à-dire que l'on bloque le transistor T2 de chaque moyen MCM de façon à isoler électriquement le condensateur DCC de la ligne de bit correspondante.

A ce moment-là, la tension VCC s'équilibre avec la tension de la ligne de bit BL à une valeur intermédiaire comprise entre Vbl et Vdd, tandis que la tension de la ligne de bit de référence BLN décroît légèrement. On active alors le signal SN, ce qui permet de lire la donnée contenue dans la cellule-mémoire, puis on active le signal RS, ce qui permet de réécrire cette donnée dans la cellule-mémoire, et par conséquent de rafraîchir celle-ci. L'activation du signal RS a ainsi classiquement pour conséquence de faire remonter la tension de la ligne de bit BL et la tension VCC à la tension d'alimentation et à refaire chuter la tension de la ligne de bit BLN à 0.

Le fait d'avoir augmenté la tension Vbl (par rapport à la tension Vdd/2) par le transfert des charges contenues dans les condensateurs DCC, a permis de garantir une tension grille-source suffisante pour permettre de rendre passants les transistors TN1 et TN2 de l'amplificateur AMLE lors de l'activation du signal SN.

Le cycle de lecture et de rafraîchissement se termine par la désactivation du signal WL, puis par celle des signaux SN et RS.

Afin de préparer la mémoire pour un nouvel accès en lecture, on précharge de nouveau les lignes de bit et les lignes de bit de référence en activant le signal PCH.

Le signal WLP, qui, dans le cas présent, a été réactivé après la désactivation du signal WLB, peut l'être en fait à tout moment avant l'activation du signal WLB et notamment de façon concomitante avec la précharge des lignes de bit et des lignes de bit de référence.

L'invention permet ainsi de façon très simple d'augmenter le mode commun de l'amplificateur de lecture/ réécriture. Cette modification, qui consiste en l'adjonction de condensateurs et de transistors, ne consomme pas d'autre énergie que celle nécessaire pour charger les condensateurs. Par ailleurs, on peut choisir avantageusement un condensateur ayant une même valeur capacitive que celle du condensateur de la cellule-mémoire. On peut également prévoir un condensateur ayant une valeur capacitive égale à un multiple de la valeur capacitive du condensateur de la cellule-mémoire, en connectant par exemple plusieurs condensateurs DCC en parallèle. Ceci permet d'adapter parfaitement le dispositif selon l'invention à l'évolution de la technologie. En effet, au fur et à mesure que la tension d'alimentation baisse avec l'évolution de la technologie, on peut rajouter un autre condensateur DCC en parallèle par rapport à une structure déjà existante pour une technologie donnée.

**Revendications**

**1.** Procédé de commande d'un accès en lecture d'une cellule-mémoire d'un plan-mémoire d'un dispositif de mémoire vive dynamique, ladite cellule-mémoire (CM) étant connectée à une ligne de bit (BL) du plan-mémoire et associée à un amplificateur de lecture/réécriture (AMLE) connecté entre la ligne de bit et une ligne de bit de référence (BLN), comportant une phase de précharge de la ligne de bit et de la ligne de bit de référence à une tension de précharge prédéterminée, et une phase de lecture et de rafraîchissement du contenu de la cellule-mémoire dans laquelle on sélectionne la cellule-mémoire et on active l'amplificateur de lecture réécriture, **caractérisé par le fait qu'**entre la phase de précharge et la phase de lecture et de rafraîchissement, on connecte respectivement sur la ligne de bit et sur la ligne de bit de référence deux condensateurs (DCC) préalablement chargés à une tension de charge (Vdd) supérieure à la tension de précharge (Vdd/2).

**2.** Procédé selon la revendication 1, **caractérisé par le fait qu'**on charge chaque condensateur (DCC) pendant une durée prédéterminée et on stoppe la charge juste avant de connecter le condensateur ainsi chargé à la ligne de bit correspondante.

**3.** Dispositif de mémoire vive dynamique, comprenant :

- un plan-mémoire comportant des colonnes formées chacune d'une ligne de bit (BL) et d'une ligne de bit de référence (BLN), sur lesquelles sont connectées des rangées de cellules-mémoire,
- un amplificateur commandable de lecture/réécriture (AMLE) connecté sur chaque colonne du plan-mémoire,
- des moyens commandables de sélection d'une rangée de cellules-mémoire,

**caractérisé par le fait qu'**il comprend en outre

- des moyens commandables de précharge de colonne (MPCH), connectés sur chaque colonne, pour précharger la ligne de bit et la ligne de bit de référence de ladite colonne à une tension de précharge prédéterminée,
- deux condensateurs (DCC) respectivement connectés à la ligne de bit et à la ligne de bit de référence d'une colonne par deux interrupteurs de connexion commandables (T2),
- des moyens commandables de charge (T1, Vdd) aptes à charger chaque condensateur à une tension de charge supérieure à la tension de précharge,
- des moyens de commande (CTL) aptes à activer les moyens de charge des condensateurs et à activer successivement les moyens de précharge, les deux interrupteurs de connexion, les moyens de sélection et l'amplificateur de lecture/réécriture.

**4.** Dispositif selon la revendication 3, **caractérisé par le fait que** les moyens de commande sont aptes à activer les moyens de charge pendant une durée prédéterminée, puis à désactiver les moyens de charge juste avant de fermer les deux interrupteurs de connexion (T2).

**5.** Dispositif selon la revendication 3 ou 4, **caractérisé par le fait que** les moyens de charge comportent pour chaque condensateur (DCC), un interrupteur de charge commandable (T1) connecté entre une source de tension délivrant ladite tension de charge (Vdd), et une borne du condensateur (DCC).

## Claims

**1.** Process for controlling a read access for a memory cell of a memory plane of a dynamic random access memory device, the said memory cell (CM) being connected to a bit line (BL) of the memory plane and associated with a read/rewrite amplifier (AMLE) connected between the bit line and a reference bit line (BLN), comprising a phase of precharging the bit line and the reference bit line to a predetermined precharge voltage, and a phase of reading and refreshing the content of the memory cell in which the memory cell is selected and the read rewrite amplifier is activated, **characterized in that** between the precharging phase and the reading and refreshing phase two capacitors (DCC) previously charged to a charging voltage (Vdd) greater than the precharge voltage (Vdd/2) are connected respectively to the bit line and to the reference bit line.

**2.** Process according to Claim 1, **characterized in that** each capacitor (DCC) is charged for a predetermined duration and the charging is halted just before connecting the capacitor thus charged to the corresponding bit line.

**3.** Dynamic random access memory device, comprising:

- a memory plane comprising columns each formed of a bit line (BL) and of a reference bit line (BLN), to which are connected rows of memory cells,
- a read/rewrite controllable amplifier (AMLE) connected to each column of the memory plane,

- controllable means of selecting a row of memory cells,

**characterized in that** it further comprises:

- controllable means of column precharging (MPCH), connected to each column, so as to precharge the bit line and the reference bit line of the said column to a predetermined precharge voltage,
- two capacitors (DCC) respectively connected to the bit line and to the reference bit line of a column by two controllable connection interrupters (T2),
- controllable means of charging (T1, Vdd) able to charge each capacitor to a charging voltage greater than the precharge voltage,
- control means (CTL) able to activate the means of charging the capacitors and to activate in succession the precharging means, the two connection interrupters, the selection means and the read/rewrite amplifier.

**4.** Device according to Claim 3, **characterized in that** the control means are able to activate the charging means for a predetermined duration, then to deactivate the charging means just before closing the two connection interrupters (T2).

**5.** Device according to Claim 3 or 4, **characterized in that** the charging means comprise for each capacitor (DCC), a controllable charging interrupter (T1) connected between a voltage source delivering the said charging voltage (Vdd), and a terminal of the capacitor (DCC).


**Patentansprüche**

**1.** Verfahren zur Steuerung eines Lesezugriffs auf eine Speicherzelle einer Speicherebene einer dynamischen Speichervorrichtung, wobei die Speicherzelle (CM) mit einer Bitleitung (BL) der Speicherebene verbunden ist und an einem Lese/Überschreib-Verstärker (AMLE) angeschlossen ist, der zwischen der Bitleitung und einer Referenzbitleitung (BLN) angeordnet ist, mit einer Phase des Voraufladens der Bitleitung und der Referenzbitleitung auf eine vorgegebene Voraufladespannung und einer Lese- und Auffrischungsphase des Inhalts der Speicherzelle, in welcher die Speicherzelle gewählt wird und der Lese/Überschreib-Verstärker aktiviert wird, **dadurch gekennzeichnet, daß** zwischen der Voraufladephase und der Lese- und Auffrischungsphase zwei Kondensatoren (DCC) mit der Bitleitung bzw. mit der Referenzbitleitung verbunden werden, die zuvor mit einer Aufladespannung (Vdd) aufgeladen wurden, die höher als die Voraufladespannung (Vdd/2) ist.

**2.** Verfahren nach Anspruch 1, **dadurch gekennzeichnet, daß** jeder Kondensator (DCC) während einer vorgegebenen Dauer aufgeladen wird und das Aufladen beendet wird, unmittelbar bevor der auf diese Weise aufgeladene Kondensator mit der entsprechenden Bitleitung verbunden wird.

**3.** Dynamische Speichervorrichtung mit:

einer Speicherebene, die Spalten aufweist, die jeweils mit einer Bitleitung (BL) und einer Referenzbitleitung (BLN) gebildet sind, an welchen Speicherzellenreihen angeschlossen sind,
einem steuerbaren Lese/Überschreib-Verstärker (AMLE), der mit jeder Spalte der Speicherebene verbunden ist,
einer steuerbaren Einrichtung zum Auswählen einer Speicherzellenreihe,

**dadurch gekennzeichnet, daß** sie ferner aufweist:

eine steuerbare Spaltenvoraufladeeinrichtung (MPCH), die mit jeder Spalte verbunden ist, um die Bitleitung und die Referenzbitleitung der Spalte auf eine vorgegebene Voraufladespannung aufzuladen,
zwei Kondensatoren (DCC), die über zwei steuerbare Verbindungsunterbrecher (T2) mit der Bitleitung bzw. der Referenzbitleitung einer Spalte verbunden sind,
eine steuerbare Aufladevorrichtung (T1, Vdd), die jeden Kondensator auf eine Aufladespannung aufladen kann, die höher als die Voraufladespannung ist,
eine Steuerungseinrichtung (CTL), die fähig ist, die Kondensatoraufladeeinrichtung zu aktivieren und der Reihe nach die Voraufladeeinrichtung, die zwei Verbindungsunterbrecher, die Auswahleinrichtung und den Lese/Überschreib-Verstärker zu aktivieren.

4. Vorrichtung nach Anspruch 3, **dadurch gekennzeichnet, daß** die Steuerungseinrichtung fähig ist, die Aufladeeinrichtung während einer vorgegebenen Zeitdauer zu aktivieren, die Aufladeeinrichtung dann zu deaktivieren, unmittelbar bevor die zwei Verbindungsunterbrecher (T2) geschlossen werden.

5. Vorrichtung nach Anspruch 3 oder 4, **dadurch gekennzeichnet, daß** die Aufladeeinrichtung für jeden Kondensator (DCC) einen steuerbaren Aufladeunterbrecher (T1) aufweist, der zwischen einer Spannungsquelle, die die Aufladespannung (Vdd) liefert, und einer Klemme des Kondensators (DCC) angeschlossen ist.

FIG.1

EP 1 168 359 B1

FIG. 2

10

FIG.3